# EUROPEAN PATENT APPLICATION

(11) **EP 0 793 388 A2**
(43) Date of publication of application: **03.09.1997**
(21) Application number: 97301358.4
(22) Date of filing: 28.02.1997
(51) Int. Cl.: H04N 7/32

(54) **Method and apparatus to calculate field motion estimations in frame pictures**

(30) Priority: 29.02.1996 US 608800
(71) Applicant: International Business Machines Corporation, Armonk, N.Y. 10504 (US)
(72) Inventor: Vail, Everett George, Binghamton, New York 13901 (US)
(74) Representative: Jennings, Michael John

(57) **Abstract**

Field motion in digital video motion pictures are calculated by partitioning the field data in such a way to allow the four required searches to be done simultaneously in two searches using duplicate search circuitry. This reduces processing time by fifty percent. This takes advantage of the fact that two of the four searches use the same current macroblock parity fl data and that the other two searches use the same current macroblock parity f2 data. The reference data can be stored in two separate arrays, or in one array with two read ports. According to an alternative, four sets of search circuitry can be utilized. By this expedient the four searches can be completed in parallel.

## Description

### Field of the Invention

The invention relates to compression of digital visual images, and more particularly to temporal compression, that is, reducing redundancy between pictures. Redundancy between pictures is reduced, or even eliminated, through the use of motion vectors.

Television pictures, including digital television pictures, are made up of two fields, one of f1 parity and one of f2 parity, with horizontal f1 parity pixel lines interleaved between horizontal f2 parity pixel lines. The lines of one parity are scanned first, and the lines of the opposite parity are scanned thereafter. This reduces "flicker".

### Background of the Invention

Within the past decade, the advent of world-wide electronic communications systems has enhanced the ways in which people can send and receive information. In particular, the capabilities of real-time video and audio systems have greatly improved in recent years. In order to provide services such as video-on-demand and videoconferencing to subscribers, an enormous amount of network bandwidth is required. In fact, network bandwidth is often the main inhibitor to the effectiveness of such systems.

In order to overcome the constraints imposed by networks, compression algorithms and systems have emerged. These algorithms and systems reduce the amount of video and audio data which must be transmitted by removing redundancy in the picture and audio sequences. At the receiving end, the picture sequence is uncompressed and may be displayed in real-time.

One example of an emerging video compression standard is the Moving Picture Experts Group ("MPEG") standard. Within the MPEG standard, video compression is defined both within a given picture and between pictures. Video compression within a picture is accomplished by conversion of the digital image from the time domain to the frequency domain by a discrete cosine transform, quantization, variable length coding, and Huffman coding. Video compression between pictures, that is, removal of temporal coding. Video compression between pictures, that is, removal of temporal redundancy, is accomplished via a process referred to as motion estimation, in which a motion vector is used to describe the translation of a set of picture elements (pels) from one picture to another.

In order to remove temporal redundancy from a picture, a 16x16 macroblock, the current macroblock, is compared to all other 16x16 macroblocks in a search area of a reference frame. The current 16x16 macroblock is mapped into the best match reference macroblock by means of a motion vector. Search circuitry or logic is used to find the best match reference block. This is the macroblock with the lowest accumulated absolute pel difference between it and the current macroblock.

Under the MPEG standard, progressive (frame) macroblocks can be encoded with motion estimation either as one macroblock (frame) or as two interlaced (field) macroblocks. Determining the best way to encode a macroblock (best match), that is by one or more frame type searches, or by four or more field type searches, depends on whether the picture type is P-type (predictive) or B-type (bi-directional). A P-type picture requires five searches in the full pel motion estimation logic, i.e., software or circuitry. The reference data for each of the searches can be from a different area of the reference picture. These same searches are required for each reference picture in B-type pictures, with the addition of bidirectional searches. The current macroblock is searched as a frame against a reference frame search area. Then the f1 lines of the current macroblock are searched against a reference f1 and a reference f2 search area. Finally the f2 lines of the current macroblock must be searched against a reference f1 and a reference f2 search area. The searches are:
1. current frame - reference frame
2. current f1 - reference f1
3. current f1 - reference f2
4. current f2 - reference f1
5. current f2 - reference f2

It is necessary to complete the searches fast enough to meet the performance requirements of real time encoding. This is an especially severe requirement when encoding B-type (bi-directional interpolated) frame pictures.

### Summary of the Invention

According to one aspect of the invention, field motion, i.e., parity field based motion vectors, are calculated in digital video motion pictures by partitioning the field data in such a way as to allow the required searches to be done simultaneously in parallel. In a first embodiment, four searches are performed simultaneously in two search operations using duplicate search circuitry. This reduces processing time by fifty percent. This also takes advantage of the fact that two of the four searches use the same current macroblock parity f1 data and that the other two searches use the same current macroblock parity f2 data. The reference data can be stored in two separate arrays, or in one array with two read ports. According to an alternative embodiment, four sets of search circuitry can be utilized. By this expedient the four searches can be completed in parallel.

First, the reference data can be partitioned in such a way as to allow searches 2 (current f1 to reference f1) and 3 (current f1 to reference f2) to be done simultaneously, and to allow searches 4 (current f2 to reference f1) and 5 (current f2 to reference f2) to be done simultaneously using duplicate search circuitry. This reduces processing time by fifty percent. This also takes advantage of the fact that searches 2 and 3 use the same current macroblock f1 data and that searches 4 and 5 use the same current macroblock f2 data. The reference data, which can be from different areas of the reference picture for each search, can be stored in two separate arrays, or in one array with two read ports.

Alternatively, four sets of search circuitry can be utilized. By this expedient the searches can be completed in parallel.

The sharing of field data combined with the performance of simultaneous searches speeds up the motion vector calculation process for temporal compression such that a reduction of temporal (inter-frame) redundancy from a video bit-stream achieves the performance requirements of real time encoding.

### The Figures

The invention will now be described in more detail, by way of example, with reference to the accompanying drawings in which:

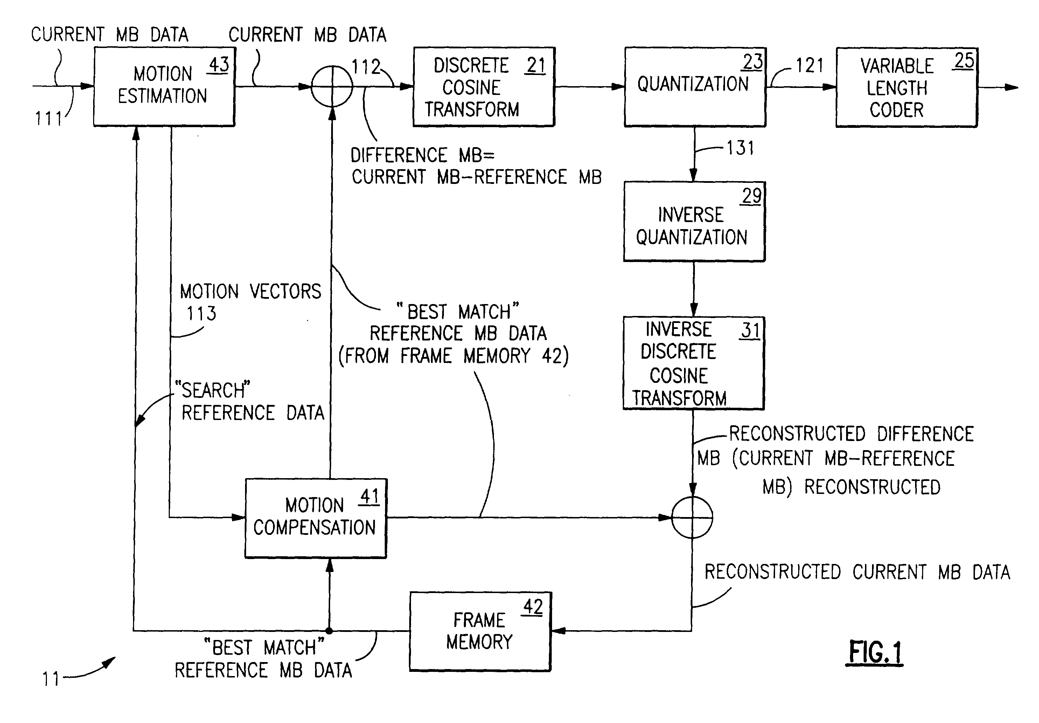

FIGURE 1 shows a flow diagram of a generalized MPEG2 compliant encoder 11, including a discrete cosine transformer 21, a quantizer 23, a variable length coder 25, an inverse quantizer 29, an inverse discrete cosine transformer 31, motion compensation 41, frame memory 42, and motion estimation 43. The data paths include the ith picture input 111, difference data 112, motion vectors 113 the picture output 121, the feedback picture for motion estimation and compensation 131, and the motion compensated picture 101. This FIGURE has the assumptions that the ith pictures exists in Frame Memory or Frame Store 42, and that the i+1th picture is being encoded with motion estimation.

FIGURE 2 illustrates the I, P, and B pictures, examples of their display and transmission orders, and forward, and backward motion prediction.

FIGURE 3 illustrates the search from the motion estimation block in the current frame or picture to the best matching block in subsequent or previous frame or picture. Elements 211 and 211' represent the same location in both pictures.

FIGURE 4 illustrates the movement of blocks in accordance with the motion vectors from their position in a previous picture to a new picture, and the previous picture's blocks adjusted after using motion vectors.

FIGURE 5 illustrates in schematic form the sequential computation of frame and field search results with the reference data stored in one array.

FIGURE 6 illustrates in schematic form the calculation of field results with partitioned reference data and duplicate search circuitry.

### Detailed Description of the Embodiments

The invention according to the preferred embodiments relates to MPEG and HDTV compliant encoders and encoding processes. The encoding functions performed by the encoder include data input, motion estimation, macroblock mode generation, data reconstruction, entropy coding, and data output. Motion estimation and compensation are the temporal compression functions. They are repetitive functions with high computational requirements, and they include intensive reconstructive processing, such as inverse discrete cosine transformation, inverse quantization, and motion compensation.

More particularly the invention relates to motion estimation, compensation, and prediction, and even more particularly to the calculation of motion vectors. Motion compensation exploits temporal redundancy by dividing the current picture into blocks, for example, macroblocks, and then searching in previously transmitted pictures for a nearby block with similar content. Only the difference between the current block pels and the predicted block pels extracted from the reference picture is actually compressed for transmission and thereafter transmitted.

The simplest method of motion compensation and prediction is to record the luminance and chrominance, i.e., intensity and color, of every pixel in an "I" picture, then record changes of luminance and chrominance, i.e., intensity and color for every specific pixel in the subsequent picture. However, this is uneconomical in transmission medium bandwidth, memory, processor capacity, and processing time because objects move between pictures, that is, pixel contents, move from one location in one picture to a different location in a subsequent picture. A more advanced idea is to use a previous or subsequent picture to predict where a block of pixels will be in a subsequent or previous picture or pictures, for example, with motion vectors, and to write the result as "predicted pictures" or "P" pictures. More particularly, this involves making a best estimate or prediction of where the pixels or macroblocks of pixels of the ith picture will be in the i-lth or i+1th picture. It is one step further to use both subsequent and previous pictures to predict where a block of pixels will be in an intermediate or "B" picture.

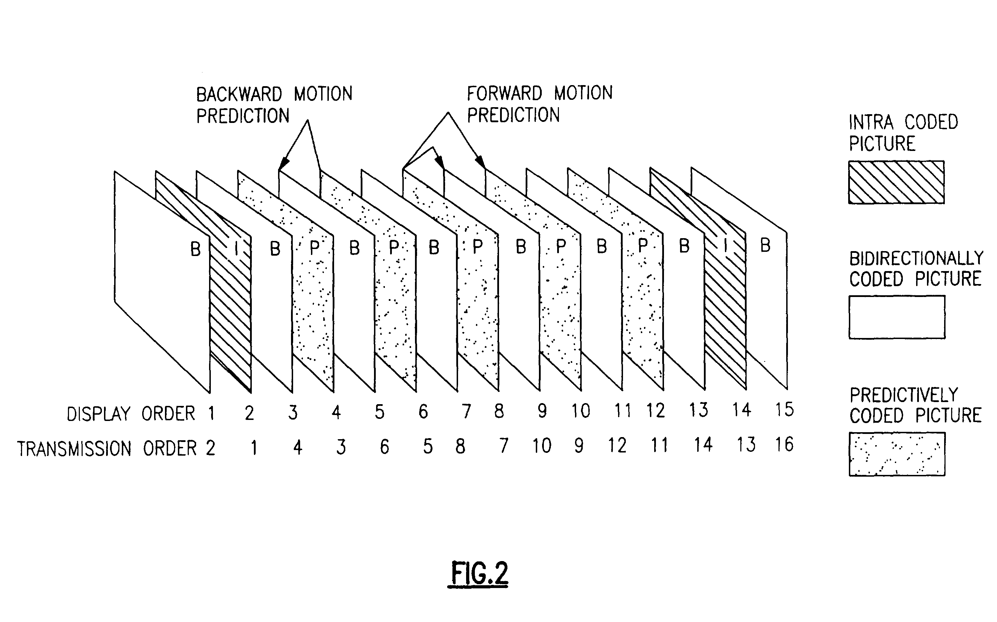

To be noted is that the picture encoding order and the picture transmission order do not necessarily match the picture display order. See FIGURE 2. For I-P-B systems the input picture transmission order is different from the encoding order, and the input pictures must be temporarily stored until used for encoding. A buffer stores this input until it is used.

For purposes of illustration, a generalized flow chart of MPEG compliant encoding is shown in Figure 1. In the flow chart the images of the ith picture and the i+1th picture are processed to generate motion vectors. The motion vectors predict where a macroblock of pixels will be in a prior and/or subsequent picture. The use of the motion vectors instead of full images is a key aspect of temporal compression in the MPEG and HDTV standards. As shown in Figure 1 the motion vectors, once generated, are used for the translation of the macroblocks of pixels, from the ith picture to the i+1th picture.

As shown in Figure 1, in the encoding process, the images of the ith picture and the i+1th picture are processed in the encoder 11 to generate motion vectors which are the form in which, for example, the i+1th and subsequent pictures are encoded and transmitted. An input image 111' of a subsequent picture goes to the Motion Estimation unit 43 of the encoder. Motion vectors 113 are formed as the output of the Motion Estimation unit 43. These vectors are used by the Motion Compensation Unit 41 to retrieve macroblock data from previous and/or future pictures, referred to as "reference" data, for output by this unit. One output of the Motion Compensation Unit 41 is negatively summed with the output from the Motion Estimation unit 43 and goes to the input of the Discrete Cosine Transformer 21. The output of the Discrete Cosine Transformer 21 is quantized in a Quantizer 23. The output of the Quantizer 23 is split into two outputs, 121 and 131; one output 121 goes to a downstream element 25 for further compression and processing before transmission, such as to a run length encoder; the other output 131 goes through reconstruction of the encoded macroblock of pixels for storage in Frame Memory 42. In the encoder shown for purposes of illustration, this second output 131 goes through an inverse quantization 29 and an inverse discrete cosine transform 31 to return a lossy version of the difference macroblock. This data is summed with the output of the Motion Compensation unit 41 and returns a lossy version of the original picture to the Frame Memory 42.

As shown in Figure 2, there are three types of pictures. There are "Intra pictures" or "I" pictures which are encoded and transmitted whole, and do not require motion vectors to be defined. These "I" pictures serve as a source of motion vectors. There are "Predicted pictures" or "P" pictures which are formed by motion vectors from a previous picture and can serve as a source of motion vectors for further pictures. Finally, there are "Bidirectional pictures" or "B" pictures which are formed by motion vectors from two other pictures, one past and one future, and can not serve as a source of motion vectors. Motion vectors are generated from "I" and "P" pictures, and are used to form "P" and "B" pictures.

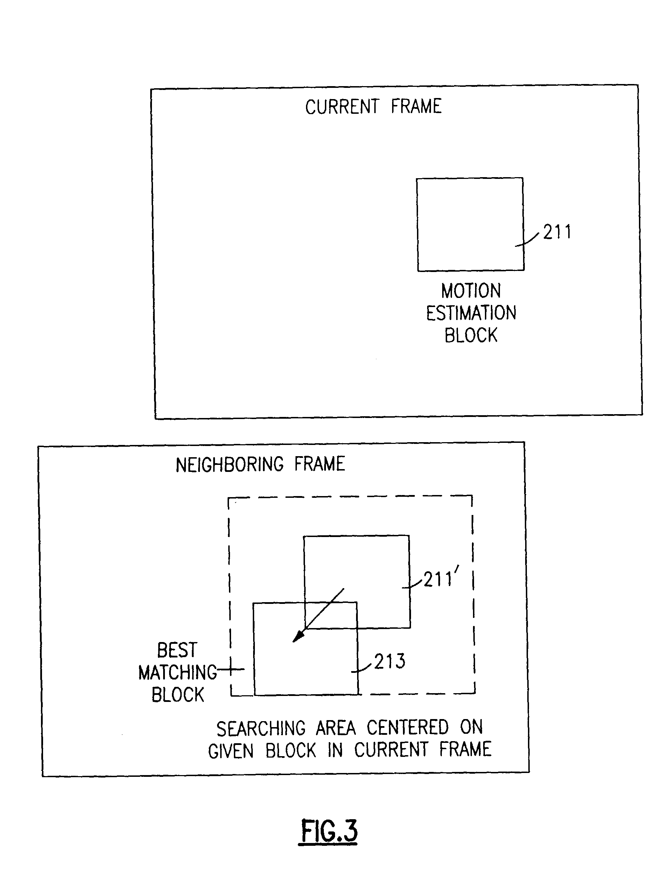

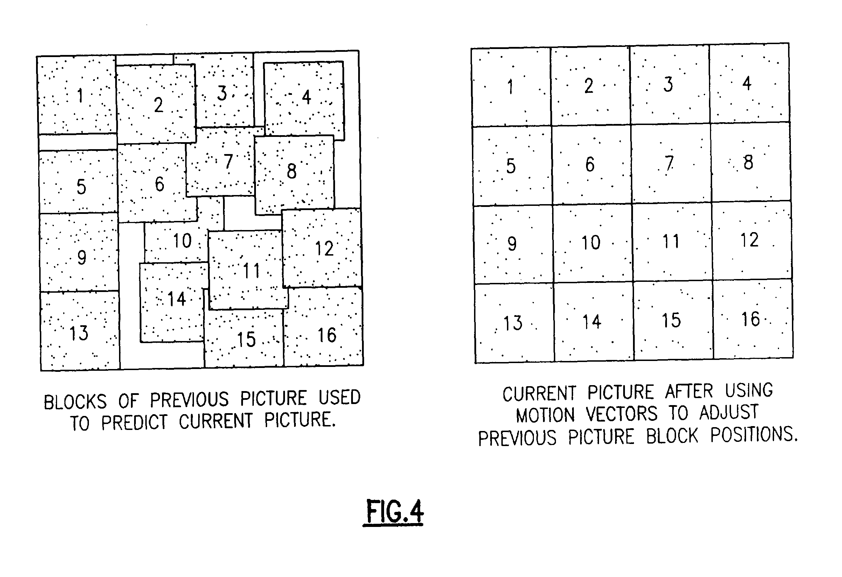

One method by which motion estimation is carried out, shown in Figure 3, is by a search from a macroblock 211 of an ith picture throughout a region of the next picture to find the best match macroblock 213. Translating the macroblocks in this way yields a pattern of macroblocks for the i+1th picture, as shown in Figure 4. In this way the ith picture is changed a small amount, e.g., by motion vectors and difference data, to generate the i+1th picture. What is encoded are the motion vectors and difference data, and not the i+1th picture itself. Motion vectors translate position of an image from picture to picture, while difference data carries changes in chrominance, luminance, and saturation, that is, changes in shading and illumination.

Returning to Figure 3, we look for a good match by starting from the same location in the ith picture as in the i+1th picture. A search window is created in the ith picture. We search for a best match within this search window. Once found, the best match motion vectors for the macroblock are coded. The coding of the best match macroblock includes a motion vector, that is, how many pixels in the y direction and how many pixels in the x direction is the best match displaced in the next picture. Also encoded is difference data, also referred to as the "prediction error", which is the difference in chrominance and luminance between the current macroblock and the best match reference macroblock.

The invention includes a method of generating motion vectors from a macroblock in a current picture to a macroblock in a past picture for inter-picture video compression. This is done in a motion picture having images of f1 and f2 parities. As described hereinbelow, the method comprises carrying out five searches for best match macroblocks:
1). current frame to reference frame,
2). current f1 field to reference f1 field,
3). current f1 field to reference f2 field,
4). current f2 field to reference f1 field, and
5). current f2 field to reference f2 field.

Motion vector generation includes selection of the endpoints of the motion vector by a best match search in a search window. This search comprises the steps of:
performing searches 2) and 3) simultaneously, and performing searches 4) and 5) simultaneously.

That is, the method of the invention comprises:
a. reading reference field data for the reference f1 and f2 fields and the current f1 field data simultaneously; and
b. reading reference field data for the reference f1 and f2 fields and the current f2 field data simultaneously.

This is especially useful in encoding "B" or "bidirectionally encoded" pictures, which is a very compute intensive process. It includes the steps of:
a. performing from a prior picture searches 2) and 3) simultaneously, and performing searches 4) and 5) simultaneously; and
b. performing from a subsequent picture searches 2) and 3) simultaneously, and performing searches 4) and 5) simultaneously.

In order to remove temporal redundancy from a picture, a 16x16 macroblock, the current macroblock, is compared to all other 16x16 macroblocks in a search area of a reference frame. The current 16x16 macroblock is mapped into the best match reference macroblock by means of a motion vector. Search circuitry or logic is used to find the best match reference block. This best match reference macroblock is the macroblock with the lowest accumulated absolute pel difference between it and the current macroblock.

Under the MPEG standard, progressive (frame) macroblocks can be encoded with motion estimation either as one macroblock (frame) or as two interlaced (field) macroblocks. Determining the best way to encode a macroblock (best match), that is by one or more frame type searches, or by four or more field type searches, depends on whether the picture type is P-type (predictive) or B-type (bi-directional). A P-type picture requires five searches in the full pel motion estimation logic, i.e., software or circuitry. The reference data for each of the searches can be from a different area of the reference picture. These same searches are required for each reference picture in B-type pictures, with the addition of bidirectional searches. The current macroblock is searched as a frame against a reference frame search area. Then the f1 lines of the current macroblock are searched against a reference f1 and a reference f2 search area. Finally the f2 lines of the current macroblock must be searched against a reference f1 and a reference f2 search area. The searches are:
1). current frame - reference frame
2). current f1 field to reference f1 field,
3). current f1 field to reference f2 field,
4). current f2 field to reference f1 field, and
5). current f2 field to reference f2 field.

The method of the invention may be carried out in an encoder for encoding digital video motion pictures. The encoder includes circuitry for generating motion vectors from a macroblock in a current picture to a macroblock in a past picture for inter-picture video compression in a motion picture having images of f1 and f2 parities. The encoder circuitry includes means for carrying out five searches for best match macroblocks. As described and enumerated above, these searches are:
1). current frame to reference frame,
2). current f1 field to reference f1 field,
3). current f1 field to reference f2 field,
4). current f2 field to reference f1 field, and
5). current f2 field to reference f2 field.

In accordance with the teachings of the invention, the circuitry performs searches 2) and 3) simultaneously, and performing searches 4) and 5) simultaneously. The circuitry accomplishes this by
a. reading reference field data for the reference f1 and f2 fields and the current f1 field data simultaneously; and
b. reading reference field data for the reference f1 and f2 fields and the current f2 field data simultaneously.

According to a particularly preferred embodiment of the invention, two areas of reference field data are read simultaneously. This may be accomplished by partitioning the reference field data and storing the said reference data into two separate arrays. Alternatively, it may be accomplished by storing the reference field data in an array with two read ports.

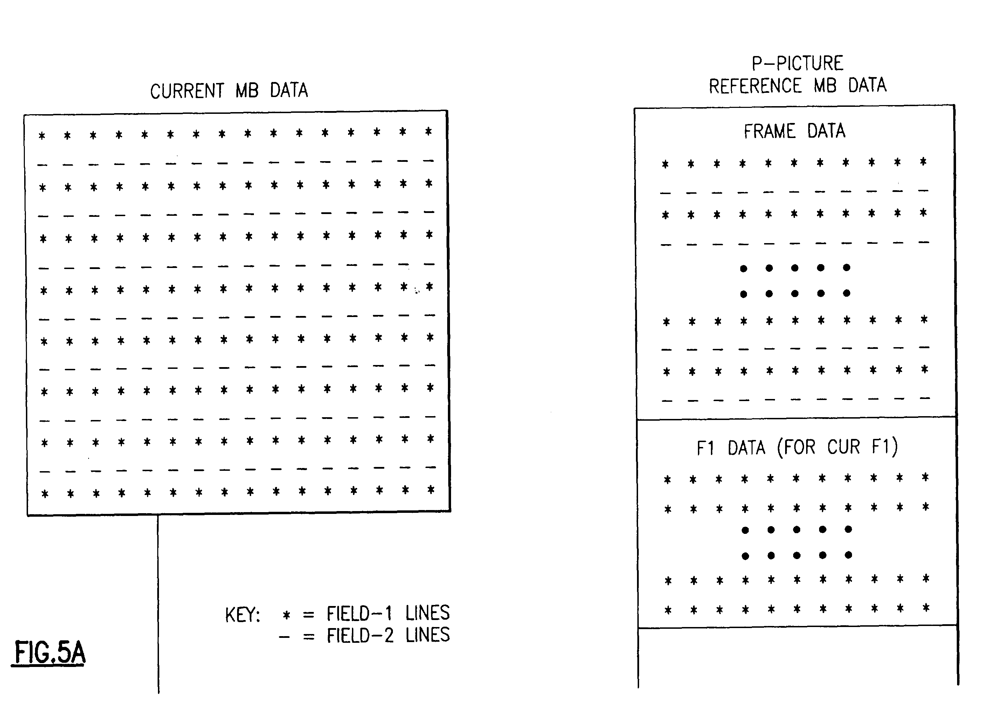

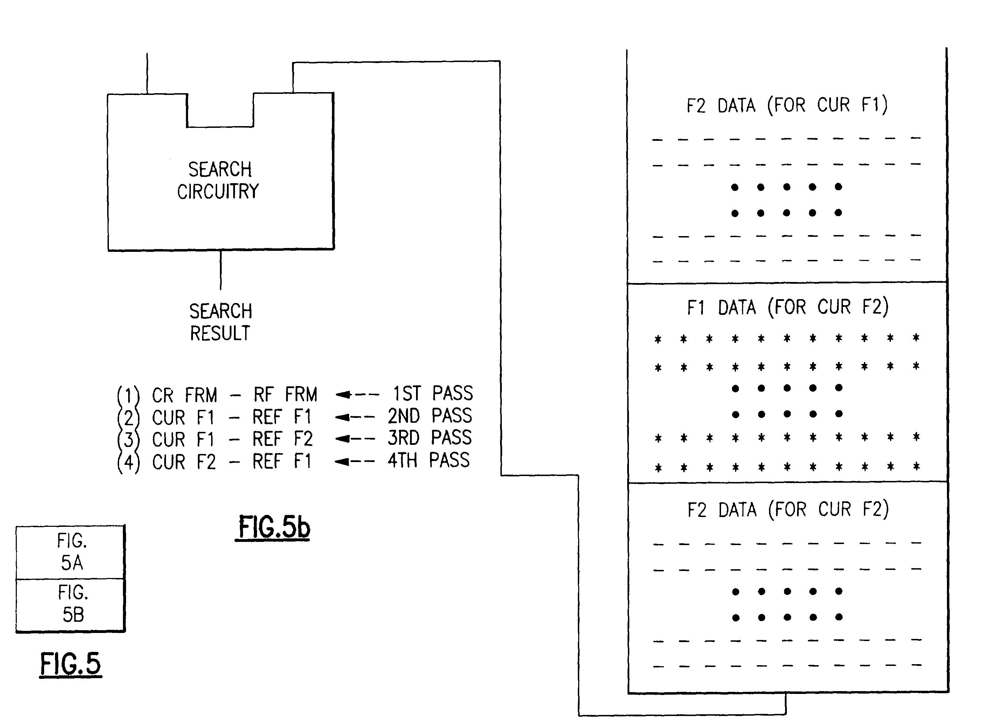

The searches are summarized above, and illustrated in FIGURE 5, which shows in schematic form the sequential computation of frame and field search results with the reference data stored in one array.

It is necessary to complete the searches fast enough to meet the performance requirements of real time encoding. This is an especially severe requirement when encoding B-type (bi-directional) frame pictures.

According to a particularly preferred embodiment of the invention, the encoder includes or is used in conjunction with RAM, i.e., DRAM, or on-chip arrays having two read ports for storing reference picture data.

According to the invention, field motion, i.e., parity field based motion vectors, are calculated in digital video motion pictures by partitioning the field data in such a way as to allow the four required searches to be done simultaneously in two searches using duplicate search circuitry. This reduces processing time by fifty percent. This also takes advantage of the fact that two of the four searches use the same current macroblock parity f1 data and that the other two searches use the same current macroblock parity f2 data. The reference data can be stored in two separate arrays, or in one array with two read ports. According to an alternative, four sets of search circuitry can be utilized. By this expedient the four searches can be completed in parallel.

According to the invention duplicate search logic, i.e., search software or search circuitry is provided, and the field data is partitioned in such a way as to allow searches 2) and 3), i.e., current f1 to reference f1 and current f1 to reference f2, to be performed substantially simultaneously, and to allow searches 4) and 5), i.e., current f2 to reference f1 and current f2 to reference f2, to be performed substantially simultaneously. If each search takes t clock cycles, simultaneous searching reduces the time for the four searches from 4t clock cycles to 2t clock cycles.

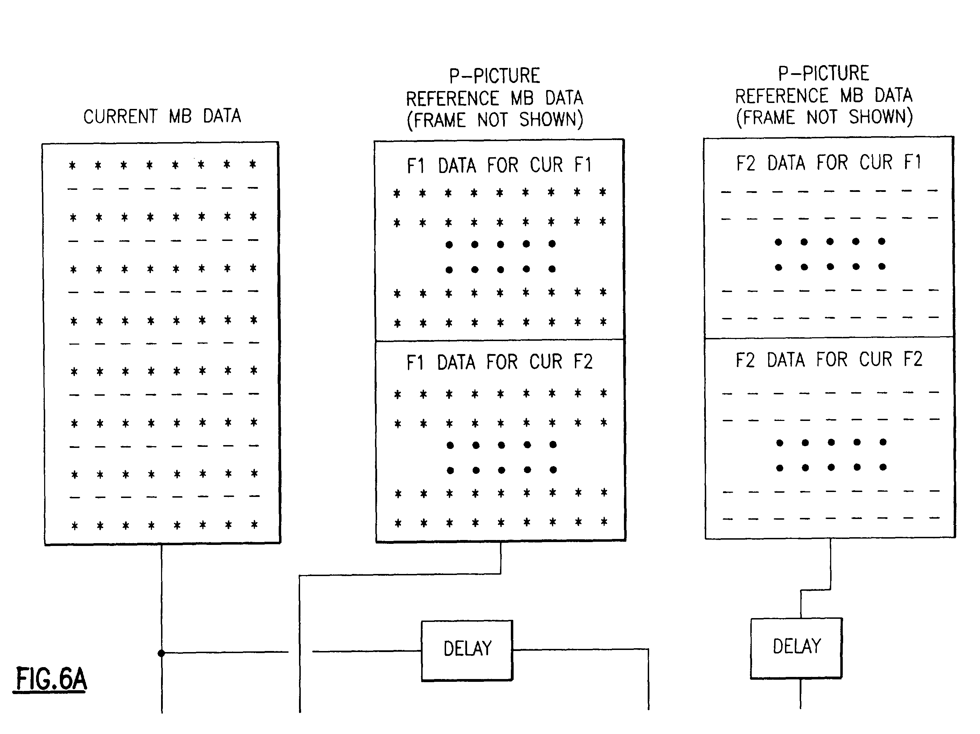

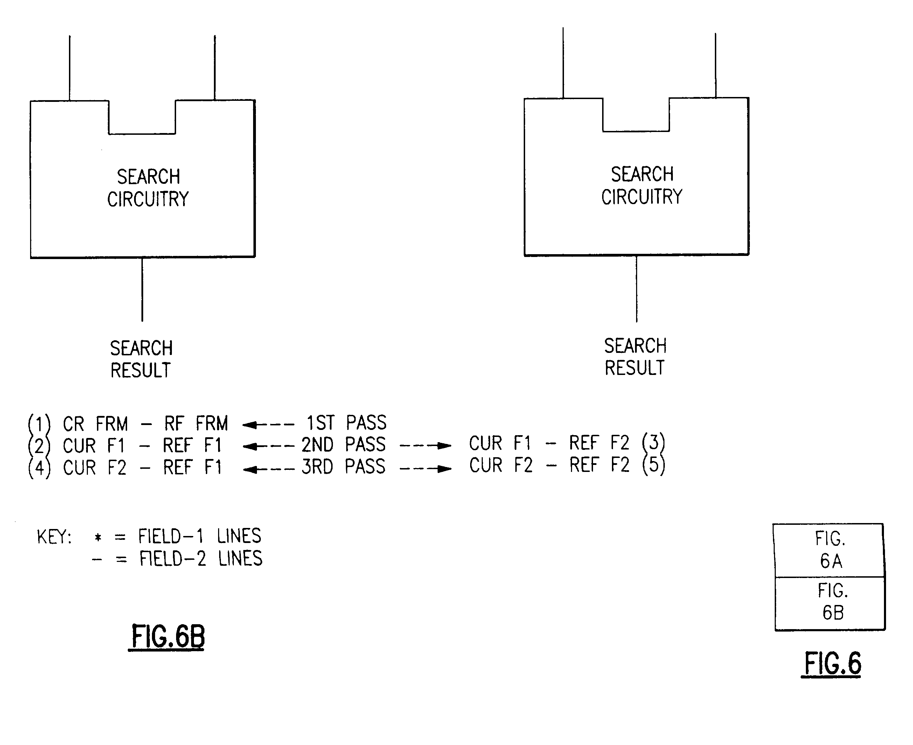

Simultaneous searching takes advantage of the fact that searches 2) and 3), i.e., current f1 to reference f1 and current f1 to reference f2, use the same current macroblock, f1, data, and that searches 4) and 5), i.e., current f2 to reference f2 and current f2 to reference f2, use the same current macroblock, f2 data. In order to complete the two searches in parallel it is necessary to read two areas of reference data at the same time. This is accomplished by partitioning the reference data and storing it in two separate arrays, or in a single array with two read ports. The addition of a second set of search logic enables the searches to be completed in parallel. This is illustrated in FIGURE 6 which shows in schematic form the calculation of field results with partitioned reference data and duplicate search circuitry.

For flexibility, an optional delay stage can be added to the second search in each search pair. At the completion of a pass through the delay stage, the search logic produces a set of accumulated absolute pixel differences corresponding to the different locations within the reference search window. Compare logic is used to evaluate the differences and select the lowest one. This activity may require more than one cycle to complete. The optional delay stage can be used to prevent both searches from completing in the same cycle. This eliminates the need to have two sets of compare logic. However, the delay stage can be dispensed with in an embodiment where two sets of compare logic are provided.

## Claims

1. A method of generating motion vectors from a macroblock in a current picture to a macroblock in a past picture for inter-picture video compression in a motion picture having images of f1 and f2 parities, which method comprises carrying out five searches for best match macroblocks,
1). current frame to reference frame,
2). current f1 field to reference f1 field,
3). current f1 field to reference f2 field,
4). current f2 field to reference f1 field, and
5). current f2 field to reference f2 field;
comprising the steps of:
a. reading reference field data for the reference f1 and f2 fields and the current f1 field data simultaneously and using the current f1 field data to perform searches of the current f1 field to the reference f1 and f2 fields simultaneously, and
b. reading reference field data for the reference f1 and f2 fields and the current f2 field data simultaneously and using the current f2 field data to perform searches of the current f2 field to the reference f1 and f2 fields simultaneously.

2. The method of claim 1 comprising encoding a "B" bidirectional picture comprising the steps of:
a. from a prior picture
i. reading prior picture reference field data for the reference f1 and f2 fields and the current f1 field data simultaneously and using the current f1 field data to perform searches of the current f1 field to the reference f1 and f2 fields simultaneously, and
ii. reading prior picture reference field data for the reference f1 and f2 fields and the current f2 field data simultaneously and using the current f2 field data to perform searches of the current f2 field to the reference f1 and f2 fields simultaneously; and
b. from a subsequent picture
i. reading subsequent picture reference field data for the reference f1 and f2 fields and the current f1 field data simultaneously and using the current f1 field data to perform searches of the current f1 field to the reference f1 and f2 fields simultaneously, and
ii. reading subsequent picture reference field data for the reference f1 and f2 fields and the current f2 field data simultaneously and using the current f2 field data to perform searches of the current f2 field to the reference f1 and f2 fields simultaneously.

3. The method of claim 1 or claim 2 comprising partitioning the reference field data and storing the said reference data into two separate arrays.

4. The method of claim 1 or claim 2 comprising partitioning the reference field data and storing said reference field data in an array with two read ports.

5. A method according to any one of the preceding claims wherein the reference data for each of the searches is from the same search area of the reference picture.

6. A method according to any one of claims 1 to 4, wherein the reference data for each of the searches is from different areas of the reference picture.

7. A method according to any one of the preceding claims comprising carrying out the searches with two sets of search circuitry.

8. A method according to any one of claims 1 to 6, comprising carrying out the searches with four sets of search circuitry.

9. An encoder for encoding digital video motion pictures including circuitry for generating motion vectors from a macroblock in a current picture to a macroblock in a past picture for inter-picture video compression in a motion picture having images of f1 and f2 parities, said circuitry including means for carrying out five searches for best match macroblocks,
1). current frame to reference frame,
2). current f1 field to reference f1 field,
3). current f1 field to reference f2 field,
4). current f2 field to reference f1 field, and
5). current f2 field to reference f2 field;
said encoder comprising:
a. means for reading reference field data for the reference f1 and f2 fields and the current f1 field data simultaneously and using the current f1 field data to perform searches of the current f1 field to the reference f1 and f2 fields simultaneously, and
b. means for reading reference field data fro the reference f1 and f2 fields and the current f2 field data simultaneously and using the current f2 field data to perform searches of the current f2 field to the reference f1 and f2 fields simultaneously.

10. The encoder of claim 9 further comprising field memory having two read ports for storing reference field data.

11. The encoder of claim 9 or claim 10 having two sets of search circuitry.

12. The encoder of claim 9 or claim 10 having four sets of search circuitry.

13. A method of generating motion vectors from a macroblock in a current picture to macroblocks in a past picture and a future picture for bidirectional inter-picture video compression in a motion picture having images of f₁ and f₂ parties, which method comprises the steps of:
a. from a prior picture
i. reading prior picture reference field data for the reference f1 and f2 fields and the current f1 field data simultaneously and using the current f1 field data to perform searches of the current f1 field to the reference f1 and f2 fields simultaneously, and
ii. reading prior picture reference field data for the reference f1 and f2 fields and the current f2 field data simultaneously and using the current f2 field data to perform searches of the current f2 field to the reference f1 and f2 fields simultaneously; and
b. from a subsequent picture
i. reading subsequent picture reference field data for the reference f1 and f2 fields and the current f1 field data simultaneously and using the current f1 field data to perform searches of the current f1 field to the reference f1 and f2 fields simultaneously, and
ii. reading subsequent picture reference field data for the reference f1 and f2 fields and the current f2 field data simultaneously and using the current f2 field data to perform searches of the current f2 field to the reference f1 and f2 fields simultaneously.
